# EUROPEAN PATENT APPLICATION

(11) **EP 2 966 702 A1**
(43) Date of publication of application: **13.01.2016**
(21) Application number: 14760700.6
(22) Date of filing: 07.03.2014
(51) Int. Cl.: H01L 51/40, H01L 21/336, H01L 21/368, H01L 29/786, H01L 51/05, H01L 51/30

(54) **ORGANIC SEMICONDUCTOR THIN FILM PRODUCTION METHOD**

(30) Priority: 08.03.2013 JP 2013047403
(71) Applicant: National University Corporation Kobe University, Kobe-shi, Hyogo 657-8501 (JP); Nippon Kayaku Kabushiki Kaisha, Chiyoda-ku Tokyo (JP)
(72) Inventor: UEDA Yasukiyo, Kobe-shi Hyogo 657-8501 (JP); MISAKI Masahiro, Kobe-shi Hyogo 657-8501 (JP); HAMADA Masahiro, Tokyo 115-8588 (JP); SADAMITSU Yuichi, Tokyo 115-8588 (JP)
(74) Representative: Gille Hrabal
(86) International application number: PCT/JP2014/056023
(87) International publication number: WO 2014/136953

(57) **Abstract**

The purpose of the present invention is to provide an organic semiconductor thin film forming method, and an organic semiconductor device production method which uses the same. This organic semiconductor thin film production method involves a step for arranging on the substrate a mold having recesses, and a step for introducing an organic semiconductor solution into the gaps formed by the recesses and the substrate.

## Description

### Technical Field

The present invention relates to a method for forming an organic semiconductor thin film, and a method for manufacturing an organic semiconductor device using the same.

### Background Art

A field-effect transistor, which is essential for organic semiconductor devices, have a structure in which an organic semiconductor thin film is formed between electrodes, and production thereof usually relied on a vacuum deposition method or the like, which is relatively expensive. Many organic compounds having high carrier mobility which have been used as a material for organic field-effect transistors are hardly dissolved in organic solvents. Inexpensive means such as coating printing could not be employed accordingly.

Solvent-soluble organic semiconductor materials realizing a practical level of mobility have been recently developed, whereby it is expected that semiconductor devices can be inexpensively produced. Various types of processes including coating methods and printing methods such as ink jetting, flexography and coating have been able to be employed, and studies have been extensively carried out, with employing these processes to form organic thin films, to manufacture organic semiconductor devices having comparatively high carrier mobility.

A method for producing a field-effect transistor having high mobility and an excellent durability by a coating method or a printing method with an organic semiconductor, however, have been not yet put in practical use. To form an organic thin film, a vacuum deposition method or a coating method such as a spin coat method or a blade coat method is usually used, but the former needs an expensive facility to carry out a vacuum process and the latter causes the loss of a large amount of material due to coating over the whole substrate. A printing method such as an inkjet method allows a material to be applied in a necessary amount on a target position. Similarly to coating methods and other printing methods, however, a process for forming crystals from a solution needs elaborate control of, for example, temperature, atmosphere and a treatment of an applied surface, in order to control the crystallographic orientation. Hence, these device production methods take much time for the formation of an organic semiconductor layer and thus have a drawback of low throughput.

In order to overcome these problems with the production, Patent Literature 1 provides a method of controlling the growth of crystals from an organic semiconductor solution in a certain direction by inclining a substrate; Patent Literature 2 provides a method of forming a thin film comprising disposing droplets of a semiconductor solution between a substrate and an inclined surface and evaporating the solvent; Patent Literatures 3 to 5 provide methods of producing single-crystalline organic semiconductor thin films by a double inkjet method; and Non Patent Literature 1 provides a method of improving the orientation comprising forming a thin film and exposing the formed film to solvent vapor. The method of Patent Literature 1 has a difficulty in inclining the substrate itself, and the methods of Patent Literatures 2 to 5 have a difficulty in selection of a solvent and need control of drying. The method described in Non Patent Literature 1 needs to use a large amount of a solvent, which negatively affects the environment, and is unsuitable for applications to high throughput production methods of organic semiconductors, such as Roll-to-Roll.

### Citation List

### Patent Literature

Patent Literature 1: JP 03-059036 A
Patent Literature 2: WO2011/040155
Patent Literature 3: JP 2012-049291 A
Patent Literature 4: 2012-043926B
Patent Literature 5: WO2012/023476

### Non Patent Literature

Non Patent Literature 1: APPLIED PHYSICS LETTERS, 94, 93307,2009

### Summary of Invention

### Technical Problem

An object of the present invention is to provide a novel method capable of conveniently, easily and stably producing an organic semiconductor thin film having high orientation (i.e. uniaxial orientation). A second object of the present invention is to provide, by utilizing the film production method, a high-throughput method capable of producing a practicable organic field-effect transistor having high mobility and on/off ratio in a large amount.

### Solution to Problem

As a result of exhaustive studies to solve the above-mentioned problems, the present inventors have found that single-domain single-crystalline organic semiconductor layers having a good orientation can easily be formed by the following: a mold is disposed on a substrate to form an enclosed space having predetermined space volumes; an organic semiconductor solution is fed to the space and its solvent is removed. Based on these findings, the present invention has been completed.

That is, the present invention relates to as follows:
[1] A method for producing an organic semiconductor thin film, comprising the step of disposing a mold having a recess(s) on a substrate, and the step of introducing an organic semiconductor solution into a space(s) made by the recesses and the substrate;
[2] The method for producing an organic semiconductor thin film according to [1], wherein the introduction of the organic semiconductor solution is followed by removing the mold to form the organic semiconductor thin film;
[3] The method for producing an organic semiconductor thin film according to [1] or [2], wherein the introduction of the organic semiconductor solution in the mold is followed by evaporating a solvent thereof to form the thin film;
[4] The method for producing an organic semiconductor thin film according to any one of [1] to [3], wherein the introduction of the organic semiconductor solution is performed by a capillary force or a mechanical action;
[5] The method for producing an organic semiconductor thin film according to any one of [1] to [4], wherein the introduction of the organic semiconductor solution and/or the removal of the mold is followed by carrying out a heat treatment to form the organic semiconductor thin film on the substrate;
[6] The method for producing an organic semiconductor thin film according to [5], wherein the heat treatment is carried out at a temperature of 20°C or higher and 200°C or lower;
[7] The method for producing an organic semiconductor thin film according to any one of [1] to [6], wherein the obtained organic semiconductor thin film is in a single domain crystal form;
[8] The method for producing an organic semiconductor thin film according to any one of [1] to [7], wherein the mold is manufactured from a curable resin, a solvent, a polymerization initiator and a curing accelerator;
[9] The method for producing an organic semiconductor thin film according to [8], wherein the curable resin comprises an epoxy resin;
[10] The method for producing an organic semiconductor thin film according to any one of [1] to [9], wherein the organic semiconductor solution comprises a low-molecular organic semiconductor compound;
[11] The method for producing an organic semiconductor thin film according to any one of [1] to [9], wherein the organic semiconductor solution comprises a high-molecular organic semiconductor compound;
[12] The method for producing an organic semiconductor thin film according to any one of [1] to [9], wherein the organic semiconductor solution comprises a mixture of a low-molecular organic semiconductor compound and a high-molecular organic semiconductor compound;
[13] The method for producing an organic semiconductor thin film according to [10] or [12], wherein the organic semiconductor solution comprises a compound represented by Formula (1): 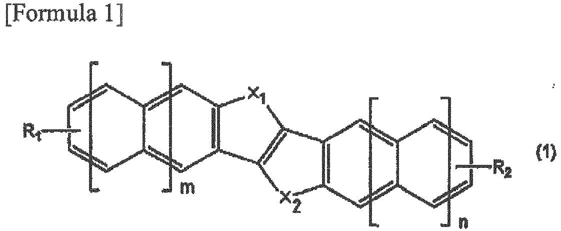 wherein X₁ and X₂ each independently represent a sulfur atom or a selenium atom; R₁ and R₂ each independently a hydrogen atom, an aliphatic hydrocarbon group, an aryl group, a heterocyclic group, an alkoxyl group or an alkoxyalkyl group, and R₁ and R₂ may be identical or different; and m and n each independently represent 0 or 1.
[14] The method for producing an organic semiconductor thin film according to [11] or [13], wherein the organic semiconductor solution further comprises a semiconductive or an insulative high-molecular compound;
[15] The method for producing an organic semiconductor thin film according to any one of [1] to [14], wherein the introduction of the organic semiconductor solution is performed by a capillary force or a mechanical action;
[16] An organic electronic device comprising an organic semiconductor thin film according to any one of [1] to [15]; and
[17] An organic transistor comprising an organic semiconductor thin film according to any one of [1] to [16].

### Advantageous Effects of Invention

By a method of forming a thin film according to the present invention, a highly oriented, typically uniaxial oriented, organic semiconductor thin film can be easily formed. Further, by a method of producing an organic semiconductor device according to the present invention, an organic semiconductor device comprising such a highly oriented organic semiconductor thin film and thus having high carrier mobility and on/off ratio can be manufactured in a high throughput.

### Brief Description of Drawings

[Fig. 1] Fig. 1 shows schematic views illustrating structures of organic thin film transistors of some embodiments as examples of organic semiconductor devices according to the present invention.
[Fig. 2] Fig. 2 shows a schematic view illustrating a process of producing an organic transistor according to an embodiment of the present invention.
[Fig. 3] Fig. 3 shows a schematic view illustrating a process of producing an organic semiconductor thin film according to the present invention.
[Fig. 4] Fig. 4 shows atomic force microscopic photographs (AFM images) and an HRED image by a transmission electron microscope and an X-ray diffraction image (XRD pattern) of a mold used in the organic thin film production method according to the present invention and a C8BTBT thin film produced by the method.
[Fig. 5] Fig. 5 shows atomic force microscopic photographs (AFM images) and HRED images by a transmission electron microscope and an X-ray diffraction image (XRD pattern) of a TIPS-pentacene thin film produced by the organic thin film production method according to the present invention.
[Fig. 6] Fig. 6 is graphs showing electric properties of a FET comprising an oriented film of C8BTBT according to the present invention.

### Description of Embodiments

The present invention will be described in detail by reference to the drawings. The present invention, however, is not limited to embodiments described in the drawings.

The present invention relates to a method for producing a single-domain single-crystalline organic semiconductor thin film, which is a uniaxially oriented film having a good orientation, by disposing a mold having a recess(es) on a substrate so as to form a gap(s), introducing an organic semiconductor material into the gap, and evaporating a solvent thereof.

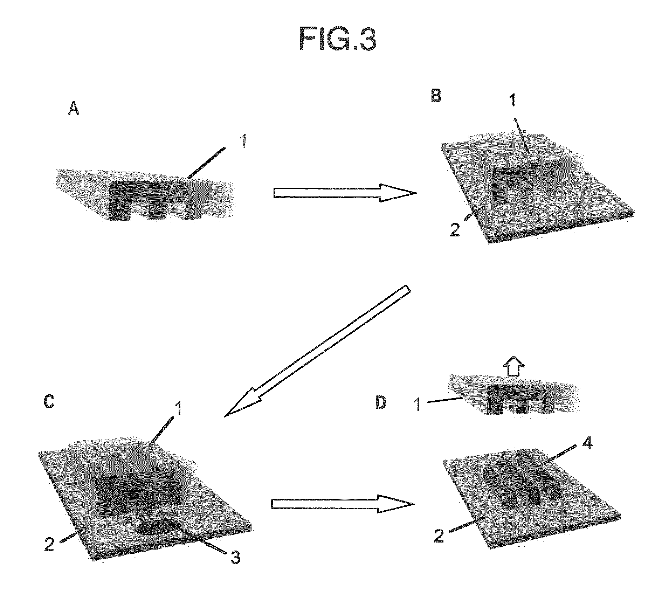

The gap(s) into which an organic semiconductor solution is introduced are formed by disposing a mold having recess(es) on a substrate. As illustrated in Fig. 3A, the mold has, for example, grooves, and a cross-section of the mold thus shows peaks and dips at a certain cycle. As illustrated in Fig. 3B, when the mold 1 is disposed on a substrate 2, the projections of the mold 1 are closely adhered on the surface of the substrate 2, and the recess and the substrate 1 together make up gaps. In the mold, both ends of the gaps each have an opening in a certain size (hole); and the hole can be used to introduce an organic semiconductor solution. However, one of or both of the ends may be closed, and holes may be provided on the upper portion or any one of the side portions of the mold instead to introduce the organic semiconductor solution through the holes. These holes are used not only to introduce the organic semiconductor solution into the gaps between the substrate and the mold, but also to discharge air and an evaporated solvent present in the gaps after the organic semiconductor solution is introduced. In the case where the substrate has a mechanism giving the same function, the mold does not need to have such holes. There is no specific prescription for the size of the holes, but it is preferable that the holes are configured so as to prevent a trouble in introducing the organic semiconductor solution and in discharging air.

In an embodiment illustrated in Fig. 3B, when the mold 1 is disposed on the substrate 2, the side of the openings is directed to the substrate: that is, the mold 1 is disposed in such a manner that the projections are contacted with the substrate. The projections need to be sufficiently closely adhered to the substrate 2 so that the organic semiconductor solution does not leak from a gap between the mold 1 and the substrate 2 during the introduction of the organic semiconductor solution. When the mold is made of a resin, the mold can easily be closely adhered and fixed by heating. In the case where the heating is carried out, the heating temperature is usually 0 to 200°C, preferably 20 to 150°C, and more preferably 50 to 100°C.

As illustrated in Figs. 3B and 3C, when the mold is disposed on the substrate, the gaps are formed between the substrate 2 and the mold 3. The organic semiconductor solution is brought into contact with the holes whose both ends are opened, and allowed to be introduced in the holes (Fig. 3C). Holes through which the organic semiconductor solution can be introduced, may be provided on the upper portion or any of the side portions of the mold. In these cases, the organic semiconductor solution may be introduced into the gaps through these holes (not illustrated in figures).

In these cases, the introduction of the organic semiconductor solution may be carried out by exerting pressure through a mechanical action (ejection, introduction under pressure, or the like), for example, by a piezoelectric device, or may be carried out by the capillary phenomenon. In consideration of the industrial application, the utilization of a mechanical action is preferable because it can control the feed amount, but in any cases the bore diameter of holes is, in the case of circular holes, usually 0.01 nm to 5 µm, preferably 0.1 nm to 3 µm, and more preferably about 1 nm to 1 µm. Here, the shapes of inlets and outlets are not especially limited. In the case of shapes other than the circular shape, the shapes having nearly the same size as the cross-section area of the above circular shape are preferable.

Methods of introducing the organic semiconductor solution into the gaps are exemplified. The methods include, as described above, a method comprising applying an organic semiconductor solution at one end (surface on which the recesses are opened) of the fixed mold, and introducing the solution into the gaps by a capillary force; and a method comprising previously forming holes previously in the mold and introducing an organic semiconductor solution into the gaps by a mechanical action through the holes. According to a more specific aspect, a mold is used as a frame of a stamp, a substrate having electrodes disposed thereon is fixed at a predetermined position, and the organic semiconductor solution is introduced simultaneously with pressing the mold. It can be said that this method enables continuous and high-throughput production of transistors. In this case, a mold in a roll form can be used to continuously produce organic semiconductor thin films.

In a step of removing a solvent according to the present invention, after a semiconductor solution is fed in the gaps, for example, a solvent is gradually evaporated at room temperature or under heating to thereby grow crystals, and the semiconductor material is sufficiently dried at a predetermined temperature to thereby form a single-domain crystalline organic semiconductor thin film of interest.

A method of removing a solvent can suitably be selected from a heat treatment by heating, and drying under a dry gas atmosphere, under the ambient atmosphere, under vacuum or the like dependent on the purpose; but in order to form a single-domain crystalline organic thin film, drying needs to be controlled at a proper drying speed through parameters including the boiling point, the vapor pressure and the like of a solution in which an organic semiconductor is dissolved. Taking these into consideration, an organic thin film is formed under selected temperature and atmosphere conditions.

It is important as described above that the crystallization speed is controlled by the heat treatment or the like for removing the solvent of an organic semiconductor solution. In the case where the heat treatment is carried out, the heating temperature is usually 0 to 300°C, preferably 10 to 250°C, and more preferably 20 to 200°C. The treatment time is usually 0.5 min to 24 hours, preferably 1 min to 10 hours, and more preferably 1 min to 1 hour. In this case, the properties of transistors may change depending on the temperature and time in the film forming, it is preferable that the heat treatment temperature and time are selected cautiously.

After an organic semiconductor thin film is obtained through the step of removing the solvent, the mold on the substrate is removed to be thereby able to obtain an organic semiconductor thin film according to the present application on a substrate (Fig. 3D).

The shape of the organic semiconductor thin film, particularly the height and the width of the thin film are defined dependent on the height and the width of the grooves (recesses) of the mold disposed.

The film thickness of the organic semiconductor thin film depends on the solid content of the organic semiconductor solution and the size (i.e. the height and the like of the grooves of the mold) of the gaps formed by the substrate and the mold; and particularly in the case of a semiconductor thin film for transistors, it may preferable have a size just covering the channel region of the transistors or a slightly larger size than that. If the size is too large, phenomena adversely affecting devices, such as increases in leakage and parasitic capacity, may occur. Therefore, it is preferable that the size of an organic semiconductor thin film is suitably determined in consideration of the sizes of electrodes, the current amounts and the properties necessary for devices, the precision of printing and the like; and the size is usually 0.2 nm to 5 µm, preferably 1 nm to 0.5 µm, and more preferably 2 nm to 0.3 µm.

Then, a method for forming a mold for use in forming the gaps will be described. As described above, the mold is preferably made of a resin to be closely adhered on a substrate. Methods for forming grooves, i.e. recesses, are not especially limited, but the grooves can be formed by applying a thermosetting or photocurable resin composition (for example, an epoxy resin and a polymerization initiator) on a template having projections with a predetermined size mentioned above, and curing the resin composition.

The material of a template having projections is not especially limited, but includes silicone resins, phenol resins, epoxy resins and melamine resins. Among these, polydimethylsiloxane (PDMS) is preferable in terms of comparatively easily curing by heat and excellent releasability.

The template can be manufactured by using a casting mold. The material of the casting mold includes inorganic materials such as silicon, quartz, glass, metal and ceramics, or organic materials such as polyimide and acrylic resins, which are solvent-insoluble and hardly swell.

A resin composition to form a mold used in a process according to the present invention will be described. The resin composition contains a curable resin and a solvent, usually together with a polymerization initiator, a curing accelerator and the like. As required, the composition can also contain various types of additives such as a surfactant, a thermosetting agent or a photocuring agent, a polymerization inhibitor, and an ultraviolet absorbent. However, the present invention is not limited thereto.

The mold can be manufactured by applying a resin composition for the mold on the above-mentioned template, and curing the resin composition and thereafter removing the mold. Meanwhile, the template is a substrate having recesses and projections on its surface, and generally tend to take air between a transitional part from a recesses to a projection and a resin film layer, and it is accordingly difficult to obtain a uniform resin film layer having excellent-flatness.

In consideration of such problems, a mold used in a process according to the present invention can be produced by a known technology (see JP 2009-122211 A). This technology is a method of forming a photosensitive resin transfer layer on a substrate which has recesses and projections on its surface, and carrying out photolithographic means on the obtained transfer layer to produce a molded article having a fine structure with a high precision and a high aspect ratio.

A resin contained in a resin composition for the mold is not especially limited as long as being capable of exhibiting functions as a mold, but includes an epoxy resins; and specific examples thereof include a bisphenol A epoxy resin, a polyfunctional bisphenol A novolac epoxy resin, an epoxy resin obtained by the reaction of the alcoholic hydroxyl groups of a bisphenol F epoxy resin with epichlorohydrin, an epoxy resin obtained by the reaction of the alcoholic hydroxyl groups of a bisphenol A epoxy resin with epichlorohydrin, and an o-cresol novolac epoxy resin.

Here, to the above resin composition, as required, various types of additives can be added, and include a thickener, a photosensitizer, a surfactant, an adhering accelerator, an antioxidant and an aggregation inhibitor.

In the case of manufacturing a mold by patterning means using a photo resist, it is desirable in terms of on the photolithographic mechanism that the photo resist is soluble to an alkali developer to be used in a development step, and it is desirable for forming a good and fine pattern that the photo resist further has sufficient curing properties with a photopolymerization initiator, a photopolymerizable monomer and the like.

A curing accelerator may be further contained in the resin composition, and includes a nitrogen-containing heterocyclic compound such as primary to tertiary amines, and a photoacid generator and a thermoacid generator, which generate an acid.

Then, an organic semiconductor compound used in a process according to the present invention will be described. The organic semiconductor compound may be a low-molecular compound or a high-molecular compound. The low-molecular compound includes a polyacene such as pentacene and TIPS-pentacene, and derivatives of polyacenes (a triphenodioxazine derivative, a triphenodithiazine derivative, a thienothiophene derivative represented by compounds (1), and the like) in which a part of the carbons of a polyacene is substituted by a heteroatom(s) such as N, S and O, or a functional group(s) such as an aryl group, an acyl group, an alkyl group, an alkoxyl group and a carbonyl group. It additionally includes a styrylbenzene derivative; a phthalocyanine; a condensed-ring tetracarboxylic acid diimides such as a naphthalenetetracarboxylic acid diimide, a perylenetetracarboxylic acid diimide and an anthracenetetracarboxylic acid diimide; and dyes such as merocyanine dyes and hemicyanine dyes. Other organic semiconductor materials include tetrathiafulvalene (TTF), tetracyanoquinodimethane (TCNQ) and complexes thereof, and an organic molecular complex such as bisethylenetetrathiafulvalene (BEDTTTF)-perchloric acid complex, a BEDTTTF-iodine complex, and a TCNQ-iodine complex.

The high-molecular compound includes a polyacetylene polymer, a polydiacetylene polymer, a polyparaphenylene polymer, a polyaniline polymer, a polythiophene polymer, a polypyrroled polymer, a polythienylenevinylene polymer, a polyaniline polymer, a polyazulene polymer, a polypyrene polymer, a polycarbazole polymer, a polyselenophene polymer, a polyfuran polymer, a poly(p-phenylene) polymer, a polyindole polymer, a polypyridazine polymer, a polysulfide polymer, a polyparaphenylenevinylene polymer, a polyethylene dioxythiophene polymer, a nucleic acids and a derivative thereof. Polymers may be singly composed of any one of these polymer or a copolymers in combinations thereof. Oligomers include a oligomer having the same repeating unit as any of the above polymers, and examples thereof include a thiophene hexamer such as α-sexythiophene, α,ω-dihexyl-α-sexythiophene, α,ω-dihexyl-α-quinquethiophene and α,ω-bis(3-butoxypropyl)-α-sexythiophene.

One example of especially preferable compounds in carrying out the present invention includes derivatives represented by the formula (1). 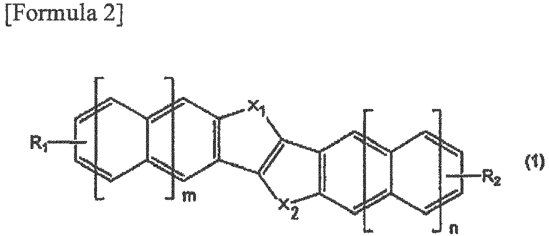 wherein X₁ and X₂ each independently represent a sulfur atom or a selenium atom; R₁ and R₂ each independently a hydrogen atom, an aliphatic hydrocarbon group, an aryl group, a heterocyclic group, an alkoxyl group or an alkoxyalkyl group, and R₁ and R₂ may be identical or different; and m and n each independently represent 0 or 1.

The aliphatic hydrocarbon group is a straight-chain, branched-chain or cyclic aliphatic hydrocarbon group, and preferably includes a straight-chain aliphatic hydrocarbon groups. The number of carbon atoms is usually 1 to 36, preferably 2 to 24, still more preferably 4 to 20, and most preferably 4 to 10. Specific examples of a straight-chain or branched-chain saturated aliphatic hydrocarbon group include a methyl group, an ethyl group, a propyl group, an isopropyl group, an n-butyl group, an isobutyl group, a t-butyl group, an n-pentyl group, an isopentyl group, a t-pentyl group, a sec-pentyl group, an n-hexyl group, an isohexyl group, an n-heptyl group, a sec-heptyl group, an n-octyl group, n-nonyl group, a sec-nonyl group, an n-decyl group, an n-undecyl group, an n-dodecyl group, an n-tridecyl group, an n-tetradecyl group, an n-pentadecyl group, an n-hexadecyl group, an n-heptadecyl group, an n-octadecyl group, an n-nonadecyl group, an n-eicosyl group, a docosyl group, an n-pentacosyl group, an n-octacosyl group, an n-tricontyl group, a 5-(n-pentyl)decyl group, a heneicosyl group, a tricosyl group, a tetracosyl group, a hexacosyl group, a heptacosyl group, a nonacosyl group, an n-triacontyl group, a squaryl group, a dotriacontyl group and a hexatriacontyl group. Specific examples of a cyclic saturated aliphatic hydrocarbon group include a cyclohexyl group, a cyclopentyl group, an adamantyl group and a norbonyl group. An n-hexyl group, an n-octyl group, an n-decyl group and an n-dodecyl group are preferable.

The aryl group includes aromatic hydrocarbon groups such as a phenyl group, a biphenyl group, a pyrene group, a xylyl group, a mesityl group, a cumenyl group, a benzyl group, a phenylethyl group, an α-methylbenzyl group, a triphenylmethyl group, a styryl group, a cinnamyl group, a biphenylyl group, a 1-naphthyl group, a 2-naphthyl group, an anthryl group and a phenanethryl group. The heterocyclic group includes an aromatic heterocyclic group containing a sulfur, an oxygen or a nitrogen atom, and preferably a 2-thienyl group and a thienothienyl group. The aryl groups and the heterocyclic groups may have as a substituent the above aliphatic hydrocarbon group such as a C4-C10 alkyl group; and in the case of having two or more substituents, the substituents may be identical or different.

The alkoxyl group includes a methoxy group, an ethoxy group, an n-propoxy group, an n-butoxy group, an n-pentyloxy group, an n-hexyloxy group, an n-heptyloxy group, an n-octyloxy group, an n-nonyloxy group, an n-decyloxy group, an n-undecyloxy group, an n-dodecyloxy group, an n-tridecyloxy group, an n-tetradecyloxy group, an n-pentadecyloxy group, an n-hexadecyloxy group, an n-heptadecyloxy group, an n-octadecyloxy group, an n-nonadecyloxy group, an n-icosyloxy group, an n-henicosyloxy group, an n-docosyloxy group, an n-tricosyloxy group, an n-tetracosyloxy group, an n-pentacosyloxy group, an n-hexacosyloxy group, an n-heptacosyloxy group, an n-octacosyloxy group, an n-nonacosyloxy group and an n-triacontyloxy group. The alkoxyl group preferably includes alkoxy groups having 1 to 20 carbon atoms such as a methoxy group, an ethoxy group, an n-propoxy group, an n-butoxy group, an n-pentyloxy group, an n-hexyloxy group, an n-heptyloxy group, an n-octyloxy group, an n-nonyloxy group, an n-decyloxy group, an n-undecyloxy group, an n-dodecyloxy group, an n-tridecyloxy group, an n-tetradecyloxy group, an n-pentadecyloxy group, an n-hexadecyloxy group, an n-heptadecyloxy group, an n-octadecyloxy group, an n-nonadecyloxy group and an n-icosyloxy group.

The alkoxyalkyl group includes a methoxymethyl group, an ethoxymethyl group, an n-propoxymethyl group, an n-butoxymethyl group, an n-pentyloxymethyl group, an n-hexyloxymethyl group, an n-heptyloxymethyl group, an n-octyloxymethyl group, an n-nonyloxymethyl group, an n-decyloxymethyl group, an n-undecyloxymethyl group, an n-dodecyloxymethyl group, an n-tridecyloxymethyl group, an n-tetradecyloxymethyl group, an n-pentadecyloxymethyl group, an n-hexadecyloxymethyl group, an n-heptadecyloxymethyl group, an n-octadecyloxymethyl group, an n-nonadecyloxymethyl group, a methoxyethyl group, an ethoxyethyl group, an n-propoxyethyl group, an n-butoxyethyl group, an n-pentyloxyethyl group, an n-hexyloxyethyl group, an n-heptyloxyethyl group, an n-octyloxyethyl group, an n-nonyloxyethyl group, an n-decyloxyethyl group, an n-undecyloxyethyl group, an n-dodecyloxyethyl group, an n-tridecyloxyethyl group, an n-tetradecyloxyethyl group, an n-pentadecyloxyethyl group, an n-hexadecyloxy ethyl group, an n-heptadecyloxyethyl group, an n-octadecyloxyethyl group, an n-nonadecyloxyethyl group, a methoxypropyl group, an ethoxypropyl group, an n-propoxypropyl group, an n-butoxypropyl group, an n-pentyloxypropyl group, an n-hexyloxypropyl group, an n-heptyloxypropyl group, an n-octyloxypropyl group, an n-nonyloxypropyl group, an n-decyloxypropyl group, a methoxybutyl group, an ethoxybutyl group, an n-propoxybutyl group, an n-butoxybutyl group, an n-pentyloxybutyl group, an n-hexyloxybutyl group, an n-heptyloxybutyl group, an n-octyloxybutyl group, an n-nonyloxybutyl group and an n-decyloxybutyl group. The alkoxyalkyl group preferably includes a methoxymethyl group, an ethoxymethyl group, an n-propoxymethyl group, an n-butoxymethyl group, an n-pentyloxymethyl group, an n-hexyloxymethyl group, a methoxyethyl group, an ethoxyethyl group, an n-propoxyethyl group, an n-butoxyethyl group, an n-pentyloxyethyl group, an n-hexyloxyethyl group, a methoxypropyl group, an ethoxypropyl group, an n-propoxypropyl group, an n-butoxypropyl group, an n-pentyloxypropyl group, an n-hexyloxypropyl group, a methoxybutyl group, an ethoxybutyl group, an n-propoxybutyl group, an n-butoxybutyl group, an n-pentyloxybutyl group, an n-hexyloxybutyl group, an n-heptyloxybutyl group, an n-octyloxybutyl group, an n-nonyloxybutyl group and an n-decyloxybutyl group.

Preferable combinations of X₁ and X₂, and R₁ and R₂ in the formula (1) are combinations of the preferable groups mentioned above, and more preferable combinations thereof are combinations of the more preferable groups mentioned above. In this case, m and n each independently represent 0 or 1.

Typical examples of a compound represented by Formula (1) include the following compounds.

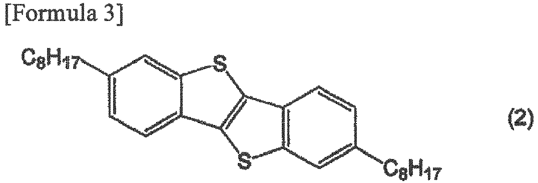

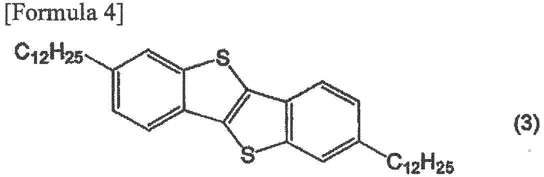

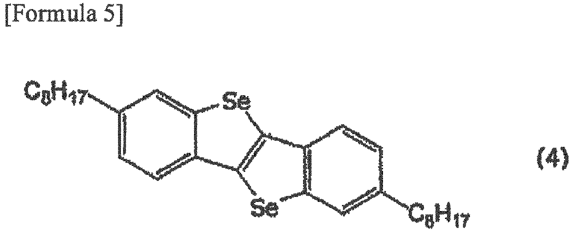

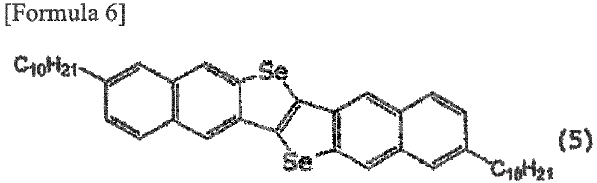

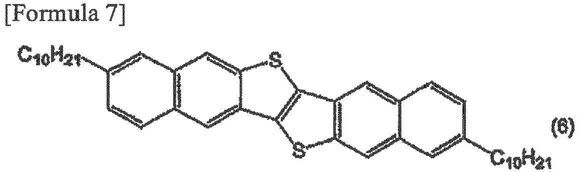

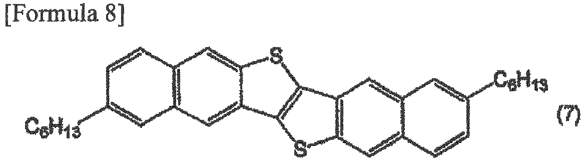

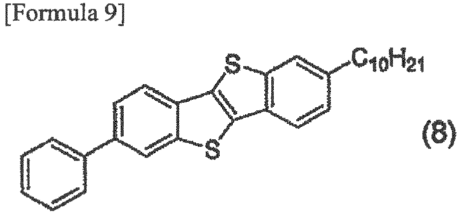

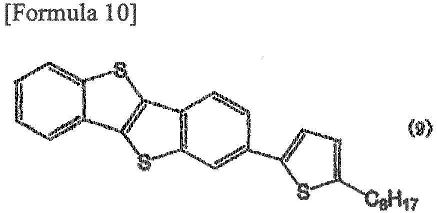

The compounds represented by Formula (1) can be synthesized by a known method, for example, described in Journal of the American Chemical Society, 2007, 129, 15732 and Advanced Materials, 2011, 23, 1222. A method of refining the compounds represented by Formula (1) is not especially limited, but includes known methods such as recrystallization, column chromatography and vacuum sublimation refining. As required, these methods may be combined.

The organic semiconductor solution is a solution in which an organic semiconductor compound is dissolved or dispersed in a solvent. The solvent to be used is not especially limited as long as a film containing the compound can be formed on a substrate, but is preferably an organic solvent, which may be used singly or as a mixture of two or more. The organic solvent halogenohydrocarbons such as dichloromethane, chloroform and dichloroethane, ethers such as diethyl ether, anisole and tetrahydrofuran, amides such as dimethylacetamide, dimethylformamide and N-methylpyrrolidone, nitriles such as acetonitrile, propionitrile and benzonitrile, alcohols such as methanol, ethanol, isopropanol and butanol, fluorinated alcohols such as octafluoropentanol and pentafluoropropanol, esters such as ethyl acetate, butyl acetate, ethyl benzoate and diethyl carbonate, aromatic hydrocarbons such as benzene, toluene, xylene, chlorobenzene, mesitylene, ethylbenzene, dichlorobenzene, chloronaphthalene and tetrahydronaphthalene, and hydrocarbons such as hexane, cyclohexane, octane, decane and tetralin. The concentration of an organic semiconductor material contained in the organic semiconductor solution is usually 0.01% to 10%, preferably 0.1 % to 8%, and more preferably 0.2% to 5%.

In the organic semiconductor solution, a low-molecular semiconductor compound and a high-molecular semiconductor compound can be mixed. The high-molecular semiconductor compound is a high-molecular compound characterized by exhibiting semiconductivity. Specific examples of the high-molecular semiconductor compound include polyacetylene polymer, polydiacetylene polymer, polyparaphenylene polymer, polyaniline polymer, polythiophene polymer, polypyrrole polymer, polythienylenevinylene polymer, polyaniline polymer, polyazulene polymer, polypyrene polymer, polycarbazole polymer, polyselenophene polymer, polyfuran polymer, poly(p-phenylene) polymer, polyindole polymer, polypyridazine polymer, polysulfide polymer, polyparaphenylenevinylene polymer, polyethylene dioxythiophene polymer, nucleic acids and derivatives thereof.

In the organic semiconductor solution, a low-molecular semiconductor compound and an insulative high-molecular compound can be also mixed. The insulative high-molecular compound is a high-molecular compound characterized by exhibiting insulation, and most of polymeric materials other than the above conductive or semiconductive polymeric materials are insulative polymeric materials. Specific examples thereof are more preferably acrylic polymers, polyethylene polymer, polymethacrylate polymer, polystyrene polymer, polyethylene terephthalate polymer, nylon polymer, polyamide polymer, polyester polymer, vinylon polymer, polyisoprene polymer, cellulose polymer, and copolymerized polymers, and derivatives thereof.

The addition amount of the polymeric materials such as the semiconductive high-molecular compound and the insulative high-molecular compound in the organic semiconductor solution is, if the polymeric materials are used, usually in the range of 0.5% to 95%, preferably 1% to 90%, still more preferably 3% to 75%, and most preferably 5% to 50%. The polymeric materials may not be used.

In the organic semiconductor solution, other additives may be added as long as not impairing the effect of interest, the other additives include a carrier generator, a conductive substance, a viscosity regulator, a surface tension regulator, a leveling agent, a penetrant, a wetting regulator and a rheology regulator. The additives are added, with respect to 1 of the total amount of the organic semiconductor materials, usually in the range of 0.01 to 10% by weight, preferably 0.05 to 5% by weight, and more preferably 0.1 to 3% by weight.

The organic semiconductor solution according to the present invention may contain the other additives, but the advantage of the present invention can be attained even if containing no other additives.

The organic semiconductor thin film can be used for organic electronic devices. Examples of the organic electronic devices include organic transistors, photoelectric conversion devices, organic solar cell devices, organic EL devices, organic light emitting transistor devices and organic semiconductor laser devices. By a method of forming a film according to the present invention, a crystalline thin film can be easily obtained. Organic transistors, organic laser devices and the like are therefore included in suitable organic electronic devices. The organic transistor will be described in detail.

The organic transistor is a device in which two electrodes (a source electrode and a drain electrode) contact with an organic semiconductor, and a current flowing between the electrodes is controlled by a voltage applied to another electrode called a gate electrode.

Generally, for organic transistor devices, there is often used a structure (Metal-Insulator-Semiconductor, MIS structure) in which a gate electrode is insulated with an insulating film. The MIS structure using a metal oxide film as the insulating film is called a MOS structure. Although there is additionally a structure (MES structure) in which a gate electrode is formed through a Schottky barrier, in the case of organic transistors, the MIS structure is often used.

Hereinafter, organic transistors will be described in more detail by way of drawings, but the present invention is not limited to these structures.

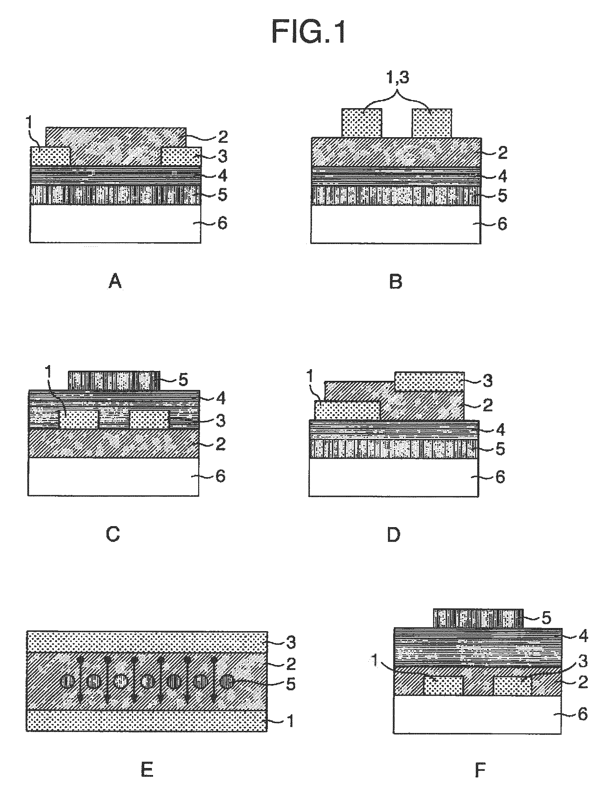

Fig. 1 illustrates some embodiments of organic transistor devices.

In each embodiment in Fig. 1, reference numeral 1 is a source electrode; reference numeral 2 is a semiconductor layer; reference numeral 3 is a drain electrode; reference numeral 4 is an insulator layer; reference numeral 5 is a gate electrode; and reference numeral 6 is a substrate. Here, the arrangement of each layer and electrode can suitably be selected according to applications of devices. In A to D and F, since a current flows in the parallel direction with the substrate, these are called lateral transistors. A is called a bottom-contact bottom-gate structure; and B is called a top-contact bottom-gate structure. Further, C has a source and a drain electrode and an insulator layer provided on a semiconductor, and has a gate electrode provided further on the insulator layer, and is called a top-contact top-gate structure. D is a structure called a top & bottom-contact bottom-gate type transistor. F is a bottom-contact top-gate structure. E is a schematic view of a transistor having a vertical structure, that is, a static induction transistor (SIT). In this SIT, since the flow of the current spreads planarly, a large amount of the carrier can migrate at one time. Further since the source electrode and the drain electrode are vertically arranged, the distance between the electrodes can be made short, so the response speed is high. Therefore, this can suitably be applied to applications in which a large current is made to flow, in which a high-speed switching is carried out, and the like. Here, in E in Fig. 1, no substrate is depicted, but in usual cases, a substrate is provided outside the source or drain electrode represented by reference numerals 1 and 3 in Fig. 1E.

Each constituting element in the each embodiment will be described.

The substrate 6 needs to hold each layer formed thereon without the each layer being separated. A material can be used therefor, for example, an insulative material such as a resin plate, a film, a paper, a glass, a quartz or a ceramic; a conductive substrate of a metal or an alloy having an insulating layer formed thereon by coating or the like; and a material in various types of combinations of resins and inorganic materials. Examples of a resin film usable include polyethylene terephthalate, polyethylene naphthalate, polyether sulfone, polyamide, polyimide, polycarbonate, cellulose triacetate and polyetherimide. When a resin film or a paper is used, devices can be made to have flexibility and become flexible and lightweight, and are improved in practicability. The thickness of the substrate is usually 1 µm to 10 mm, and preferably 10 µm to 2 mm.

For the source electrode 1, the drain electrode 3 and the gate electrode 5, materials having conductivity are used. There can be used, for example, metals such as platinum, gold, silver, aluminum, chromium, tungsten, tantalum, nickel, cobalt, copper, iron, lead, tin, titanium, indium, palladium, molybdenum, magnesium, calcium, barium, lithium, potassium and sodium, and alloys containing these; conductive oxides such as InO₂, ZnO₂, SnO₂ and ITO; conductive high-molecular compounds such as polyaniline, polypyrrole, polythiophene, polyacethylene, polyparaphenylenevinylene and polydiacetylene; semiconductors such as silicon, germanium and gallium arsenide; and carbon materials such as carbon black, fullerene, carbon nanotubes, graphite and graphene. Further the conductive high-molecular compounds and the semiconductors may be doped. Examples of the dopant include inorganic acids such as hydrochloric acid and sulfuric acid; organic acids having an acidic functional group, such as sulfonic acid; Lewis acids such as PF₅, AsF₅ and FeCl₃; halogen atoms such as iodine; and metal atoms such as lithium, sodium and potassium. Boron, phosphorus, arsenic and the like are used as a dopant for inorganic semiconductors such as silicon in many cases.

Further, conductive composite materials are also used in which carbon black, metal particles or the like are dispersed in the above dopant. For the source electrode 1 and the drain electrode 3, which directly contact with a semiconductor, in order to reduce the contact resistance, the selection of a suitable work function, the surface treatment and the like become significant.

Further, the distance (channel length) between the source electrode and the drain electrode is an important factor to determine properties of devices. The channel length is usually 0.01 to 300 µm, and preferably 0.1 to 100 µm. With a short channel length, although the extractable current amount increases, conversely since the short channel effect including the influence of the contact resistance generates to thereby make the control difficult, a reasonable channel length is needed. The width (channel width) between the source and drain electrodes is usually 1 to 1,000 µm, and preferably 5 to 200 µm. Further with respect to the channel width, by making the structure of the electrode to be of a comb-type or the like, a longer channel width can be formed; and a proper length needs to be made depending on the necessary current amount, the device structure and the like.

The respective structures (shapes) of the source electrode and the drain electrode will be described. The structures of the source electrode and the drain electrode may be identical or different.

In the case of a bottom-contact structure, each electrode is generally fabricated by using lithography, and the each electrode is preferably formed in a rectangular parallelepiped. The printing precision by various types of printing methods has recently improved and electrodes come to be enabled to be fabricated well precisely by using means such as inkjet printing, gravure printing or screen printing. In the case of a top-contact structure in which electrodes are on a semiconductor, the electrodes can be vapor deposited by using a shadow mask or the like. By using means such as inkjet, electrode patterns come to be enabled to be directly printed and formed. The length of the electrodes is the same as the above channel width. The width of the electrodes is not especially prescribed, but a shorter one in the range of being capable of stabilizing the electric properties is preferable in order to make the area of devices small. The width of the electrodes is usually 0.1 to 1,000 µm, and preferably 0.5 to 100 µm. The thickness of the electrodes is usually 0.1 to 1,000 nm, preferably 1 to 500 nm, and still more preferably 5 to 200 nm. Interconnects are connected to the each electrode 1, 3 and 5, and the interconnects are also fabricated of nearly the same material as in the electrodes.

A material having insulation is used as the insulator layer 4. There can be used, for example, polymers such as polyparaxylylene, polyacrylate, polymethyl methacrylate, polystyrene, polyvinylphenol, polyolefin, polyamide, polyimide, polycarbonate, polyester, polyvinyl alcohol, polyvinyl acetate, polyurethane, polysulfone, fluororesins, epoxy resins and phenol resins, and copolymers in combinations thereof; metal oxides such as silicon oxide, aluminum oxide, titanium oxide and tantalum oxide; ferroelectric metal oxides such as SrTiO₃ and BaTiO₃; dielectrics such as nitrides such as silicon nitride and aluminum nitride, sulfides, fluorides and polymers in which particles of these dielectrics are dispersed. As the insulator layer, there can be preferably used one having a high electric insulation property in order to make the leak current small. Thereby, the film thickness can be made small and the insulation capacity can be made large; then, the extractable current can be made large. Further in order to improve the mobility of the semiconductor, it is preferable that the surface energy of the insulator layer surface is reduced and the layer is a smooth film having no unevenness. Therefor, a self-organized unimolecular film or a two-layered insulator layer is formed in some cases. The film thickness of the insulator layer 4, depending on the material, usually 0.1 nm to 100 µm, preferably 0.5 nm to 50 µm, and more preferably 1 nm to 10 µm.

In the organic transistors, as required, other layers can be provided, for example, between a substrate layer and an insulating film layer, and the insulating film layer and a semiconductor layer, and on the outer surfaces of the devices. For example, if a protection layer is formed directly or through another layer on an organic semiconductor layer, the influence of outside air such as humidity can be made small. There is also brought about an advantage of being capable of stabilizing the electric properties, including being capable of raising the on/off ratio of the organic transistor devices.

The material of the above protection layer is not especially limited, but there are preferably used, for example, films composed of various types of resins such as epoxy resins, acryl resins of polymethyl methacrylate or the like, polyurethane, polyimide, polyvinyl alcohol, fluororesins and polyolefin; inorganic oxide films of silicon oxide, aluminum oxide, silicon nitride or the like; and films composed of dielectrics such as nitride films, and particularly resins (polymers) having a low permeability of oxygen and moisture and a low water absorption are preferable. Gas-barrier protection materials developed for organic EL displays can also be used. The film thickness of the protection layer can be optionally selected according to its purpose, but is usually 100 nm to 1 mm.

Further by previously subjecting the substrate or the insulator layer on which an organic semiconductor layer is stacked to a surface modification or a surface treatment, properties as the organic transistor devices can be improved. For example, by regulating the degree of hydrophilicity/hydrophobicity of the substrate surface, the film quality and the film formability of the film to be formed thereon can be improved. The properties of the organic semiconductor material largely change in some cases particularly depending on the condition of the film including the orientation of its molecules. Hence, it is conceivable that the surface treatment to the substrate, the insulator layer or the like controls the molecular orientation of the interfacial portion with the organic semiconductor layer to be thereafter formed as the film, and the reduction of trap sites on the substrate or the insulator layer improves properties such as the carrier mobility.

The trap site refers to a functional group, for example, like a hydroxyl group, present on the untreated substrate; and when such functional groups are present, electrons are attracted to the functional groups, and the carrier mobility consequently decreases. Therefore, the reduction of the trap sites is effective for the improvement of properties including the carrier mobility in many cases.

Examples of the surface treatment to improve the properties as described above include a self-organized unimolecular film treatment using hexamethyldisilazane, octyltrichlorosilane, octadecyltrichlorosilane or the like; a surface treatment using a polymer or the like; an acid treatment using hydrochloric acid, sulfuric acid, acetic acid or the like; an alkali treatment using sodium hydroxide, potassium hydroxide, calcium hydroxide, ammonia or the like; an ozone treatment; a fluorination treatment; a plasma treatment using oxygen, argon or the like; a treatment of forming a Langmuir-Blodgett film; a treatment of forming a thin film of another insulator or a semiconductor; a mechanical treatment; an electric treatment using corona discharge or the like; a rubbing treatment utilizing fibers or the like; and combinations thereof.

In these embodiments, methods for providing each layer of, for example, the substrate layer and the insulating film layer, the insulating film layer and the organic semiconductor layer, and the like can suitably be selected from the above-mentioned vacuum process and solution process.

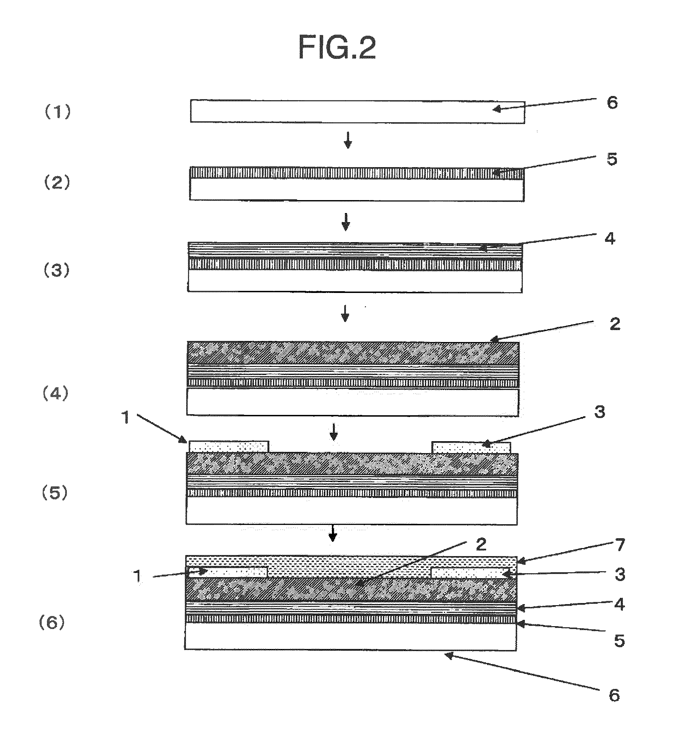

Then, the method for producing an organic transistor device according to the present invention will be described hereinafter by taking as an example the top-contact bottom-gate type organic transistor illustrated in the embodiment B of Fig. 1 and by way of Fig. 2. This production method can be similarly applied to organic transistors and the like of the other embodiments described before.

### (Substrate of organic transistor, and substrate treatment)

The organic transistor according to the present invention is fabricated by providing various types of necessary layers and electrodes on the substrate 6 (see Fig. 2(1)). As the substrate, one described in the above can be used. The above-mentioned surface treatment may be carried out on the substrate. A smaller thickness of the substrate 6 in the range of not inhibiting necessary functions is better. The thickness is, though depending on the material, usually 1 µm to 10 mm, and preferably 5 µm to 5 mm. Further as required, the substrate can be made to have a function of an electrode.

### (Formation of gate electrode)

The gate electrode 5 is formed on the substrate 6 (see Fig. 2(2)). As the electrode material, one described in the above is used. As a method for forming an electrode film, various types of methods can be used, and there are employed, for example, a vacuum deposition method, a sputtering method, a coating method, a thermal transfer method, a printing method, and a sol-gel method. During the film formation or after the film formation, as required, patterning is preferably carried out so as to make a desired shape. As a patterning method, various types of methods can be used, but examples thereof include photolithography in which the patterning and the etching of a photo resist are combined. Patterning may further be carried out by utilizing means of a vapor deposition method and a sputtering method using a shadow mask, printing methods such as inkjet printing, screen printing, offset printing and letterpress printing, soft lithography such as a micro contact printing method, and means in combinations of two or more thereof. The film thickness of the gate electrode 5 is, though depending on the material, usually 0.1 nm to 10 µm, preferably 0.5 nm to 5 µm, and more preferably 1 nm to 3 µm. In the case of serving both as the gate electrode and the substrate, the thickness may be larger than the above film thickness.

### (Formation of insulator layer)

The insulator layer 4 is formed on the gate electrode 5 (see Fig. 2(3)). As the insulator material, the material described in the above can be used. For the formation of the insulator layer 4, various types of methods can be used. Examples thereof include coating methods such as spin coating, spray coating, dip coating, casting, bar coating, blade coating, die coating and slit coating, printing methods such as screen printing, offset printing and inkjet, and dry processes such as a vacuum deposition method, a molecular beam epitaxial growth method, an ion cluster beam method, an ion plating method, a sputtering method, an atmospheric plasma method and a CVD method. There are additionally employed a sol-gel method, a method in which an oxide film is formed on a metal, like alumite on aluminum and silicon oxide on silicon, by a thermal oxidation method or the like, and other methods. Here, in order to well orient molecules constituting the semiconductor at the interface of a contacting part of the insulator layer and the semiconductor layer, for example, molecules of a compound represented by the above formula (1) or (2), the insulator layer may be subjected to a predetermined surface treatment. As means of the surface treatment, the same one as the surface treatment for the substrate can be used. The thickness of the insulator layer 4 is preferably as thin as possible because the electric amount to be extracted can be increased by increasing the electric capacity. At this time, if the thickness is thin, since the leak current increases, the thickness is preferably thinner in the range of not impairing the function. The thickness is usually 0.1 nm to 100 µm, preferably 0.5 nm to 50 µm, and more preferably 5 nm to 10 µm.

The organic semiconductor layer (see Fig. 2(4)) formed according to the present invention is allowed to be further improved in the properties by a post-treatment. The improvement and the stabilization of the organic semiconductor properties can be achieved, for example, by a heat treatment, for reasons that the heat treatment relaxes strains in the film generated during the film formation, reduces pinholes and the like, can control the arrangement and orientation in the film, and otherwise. Carrying out the heat treatment in fabrication of the organic transistor according to the present invention is effective for the improvement of the properties. The heat treatment is carried out by heating the substrate after the organic semiconductor layer is formed. The temperature of the heat treatment is not especially limited, but usually from room temperature to about 150°C, preferably 40 to 120°C, and more preferably 45 to 100°C. The heat treatment time at this time is not especially limited, but usually 10 sec to 24 hours, and preferably about 30 sec to 3 hours. The atmosphere at this time may be the air, but may be an inert atmosphere such as nitrogen or argon. Additionally, the control and the like of the film shape by a solvent vapor are allowed.

### (Formation of source electrode and drain electrode)

The formation method and the like of the source electrode 1 and the drain electrode 3 are according to the case of the gate electrode 5 (see Fig. 2(5)). Further in order to reduce the contact resistance with the organic semiconductor layer, various types of additives are allowed to be used. In the present-structure bottom-gate top-contact type transistor, the vapor deposition method using a metal mask is used in many cases. The film thickness at this time is usually 10 to 200 nm, and preferably 20 to 100 nm.

### (Protection layer)

When the protection layer 7 is formed on the organic semiconductor layer, the influence of the air atmosphere can be minimized, and there is also brought about an advantage of being capable of stabilizing the electric properties of the organic transistor (see Fig. 2(6)). As the material for the protection layer, the above material is used. An optional film thickness can be employed according to the purpose, but the thickness of the protection layer 7 is usually 100 nm to 1 mm. For formation of the film of the protection layer, various types of methods can be employed, but in the case where the protection layer is composed of a resin, examples of the methods include a method in which a resin solution is applied, and thereafter dried to thereby make a resin film; and a method in which a resin monomer is applied or vapor deposited, and thereafter polymerized. After the film forming, a crosslinking treatment may be carried out. In the case where the protection layer is composed of an inorganic substance, there can be used, for example, formation methods in vacuum processes such as a sputtering method and a vapor deposition method, and formation methods in solution processes such as a sol-gel method.

In the organic transistor, in addition to on the organic semiconductor layer, as required, a protection layer may be provided further between each layer. These layers are helpful in stabilizing the electric properties of the organic transistor in some cases.

When a thin film is produced by the present production method, an organic transistor can be produced in a comparatively low-temperature process. Therefore, flexible materials such as plastic plates and plastic films, which cannot be used under the condition of being exposed to high temperatures, can be used as the substrate. As a result, devices which are lightweight and excellent in flexibility are enabled to be produced, and can be utilized as switching devices of active matrices of displays, and the like. Examples of the displays include liquid crystal displays, polymer dispersion-type liquid crystal displays, electrophoresis-type displays, EL displays, electrochromic displays, and particle rotation-type displays. The devices can be utilized also as digital devices and analog devices such as memory circuit devices, signal driver circuit devices and signal processing circuit devices; and by combining these, IC cards and IC tags can be fabricated. Further since the organic semiconductor device according to the present invention can cause its properties to be changed by external stimuli such as chemical substances, the device can be anticipated to be utilized also as an FET sensor.

### Examples

Hereinafter, the present invention will be described specifically by way of Examples, but the present invention is not limited to these Examples. The structures of field-effect transistors were confirmed by an atomic force microscope (hereinafter, abbreviated to AFM)(apparatus name: Seiko Instruments SPI3700), a transmission electron microscope (hereinafter, abbreviated to TEM)(apparatus name: Hitachi H-7100), and an XRD (X-ray diffractometer)(apparatus name: Rigaku RINT2000); and the evaluations of semiconductor properties were measured by a semiconductor analyzer Keithly 4200.

### Example 1

### 1.1 Production of casting mold

To produce a template, a commercially available CD-R made of a polycarbonate was used as a casting mold. The CD-R was constituted of, from the underside, a resin layer made of a polycarbonate, a recording layer of an organic dye thin film, a reflection layer made of a metal, and a protection layer with a label surface. Among these, the resin layer was used as a casting mold. In order to use the resin layer as a casting mold, the reflection layer was removed (by using forceps or a Cellotape(R)). The resin layer was cleaned with ethanol for the purpose of completely removing the remaining recording layer on the resin layer.

### 1.2 Production of template

A template composed of a polydimethylsiloxane (PDMS) was produced by using the above polycarbonate mold. First, a PDMS (base) and a curing agent were mixed in a weight ratio of 10:1. This gelatinous PDMS was injected on the casting mold made from the CD-R. The PDMS was cured at 80°C for 2 hours, and a solid PDMS was removed.

### 1.3 Production of epoxy mold

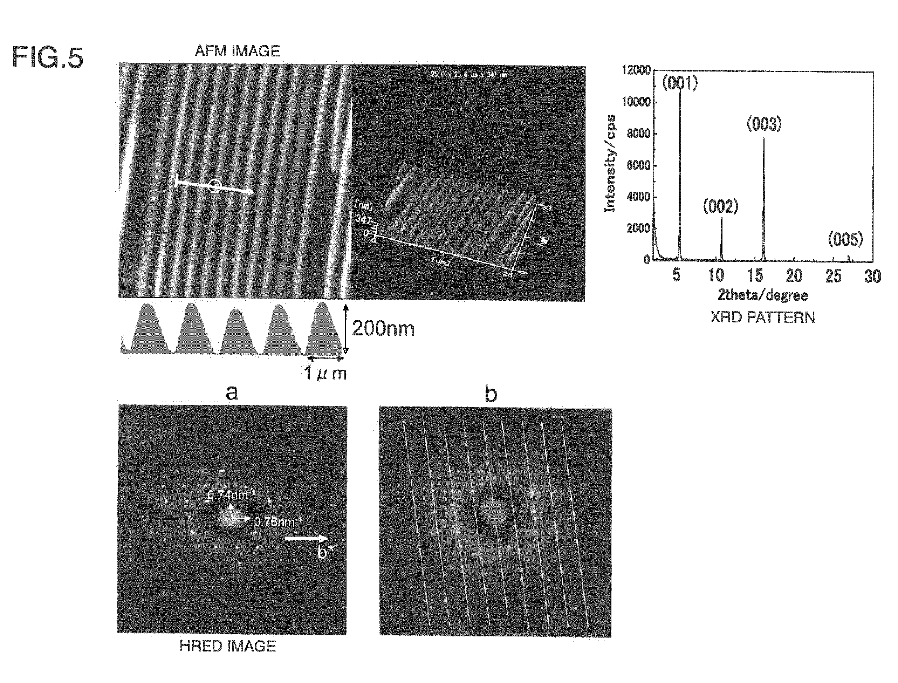

First, a liquid epoxy resin was prepared. As an epoxy resin, Oken Epok 812 set(manufactured by Okenshoji Co., Ltd) was used. The liquid epoxy was prepared by mixing Epok 812, dodecenylsuccinic anhydride (DDSA) and methylnadic anhydride (MNA) in a volume ratio of 23:15:12, adding tridimethylaminomethylphenol (manufactured by Nisshin EM Corp., trade name: DMP30) of 1.5% to the total amount as a polymerization initiator, and stirring the mixture. Subsequently, the liquid epoxy resin was deaerated in vacuum for 1 hour, poured on the PDMS template, and thermally cured at 60°C for 6 hours to obtain a solid epoxy mold. The mold was removed to obtain a stamp (mold) in a shape indicated by an AFM image in Fig. 5.

### 1.4 Production of uniaxially oriented C8BTBT (compound (2) as a specific example) film

A C8BTBT chlorobenzene solution (1 % by weight) was prepared. A substrate (Si or glass) was subjected to ultrasonic cleaning using a detergent, an ion-exchange water and acetone each for 15 min. The epoxy mold having a groove structure at 1.6 µm cycle (i.e. a structure having recesses) was put on the substrate in the air atmosphere, and heated at 80°C to 90°C for 2 min to cause the mold and the substrate to closely adhere to each other. The C8BTBT solution was put at the openings of holes at room temperature; and the C8BTBT solution was introduced into the gaps formed by the substrate and the recesses by a capillary force. After the solvent evaporated, the mold was removed to obtain a C8BTBT thin film.

### 2. Structural Evaluation of uniaxially oriented C8BTBT film

### 2.1 Observation by AFM of C8BTBT uniaxially oriented film

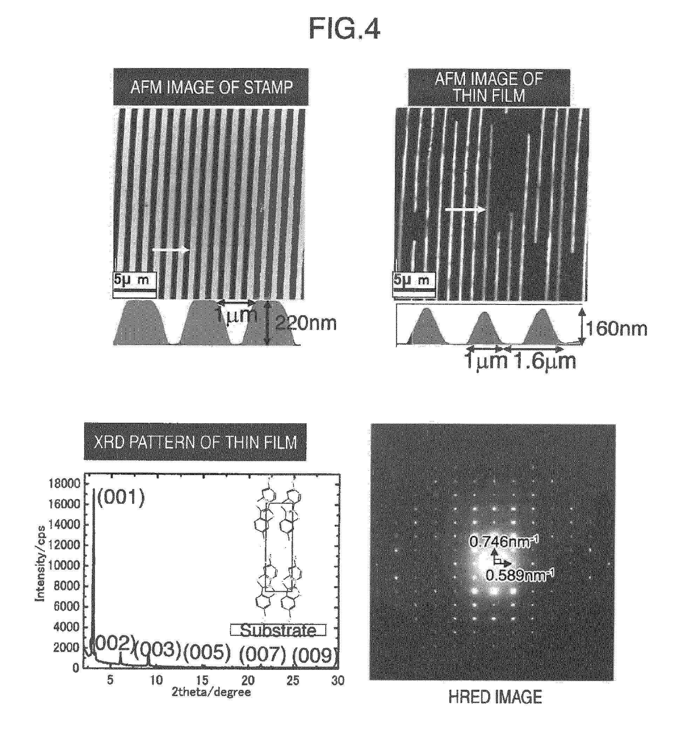

It was observed by cross-sectional profiling that the height of the linear films was about 160 nm, which corresponded to a reduction of 60 nm from 220 nm being the height of the grooves of the mold; and this is considered to corresponded to the amount of the evaporated solvent during the drying. The pitch widths of the films were about 1.6 µm, and the widths of the linear films were about 1 µm, which were coincident with the groove width of the mold (see Fig. 4).

### 2.2 TEM observation and XRD measurement of uniaxially oriented C8BTBT film

The line shape of the C8BTBT corresponding to the groove cycle of the mold was confirmed in the TEM image. The HRED image formed a net pattern with diffraction spots corresponding to spacings of 0.746 nm⁻¹ and 0.589 nm⁻¹, which was coincident with a diffraction image by c-axis projection. Since the HRED was diffraction from a region of about 150 µm in diameter, it was found that the C8BTBT in the line shape crystallized like a single crystal and took the same orientation. The b* axis of the C8BTBT crystals was parallel to the groove direction of the mold (see Fig. 4). The C8BTBT lines were observed also by XRD. It was found from the XRD and HRED images that the line shapes of the C8BTBT were single crystals and had the same orientation, and had the vertical orientation in which the C8BTBT adhered to the substrate through side chains thereof.

### 3. Evaluation of transistor properties

### 3.1 Cleaning substrate

As a substrate, silicon (oxidized film: 300 nm) was used; the silicon was immersed in a persulfuric acid solution prepared by mixing hydrogen peroxide and sulfuric acid in a proportion of 1:4, and heated at about 100°C for 20 min, and then subjected to ultrasonic cleaning with an ion-exchange water and isopropanol each three times for 5 min and one time for 3 min. Thereafter, the substrate was put in a beaker nearly half filled with isopropanol, which was then boiled at around 120°C for about 10 min, and then subjected to UV ozone cleaning for 12 min.

### 3.2 Production of oriented C8BTBT film

A C8BTBT thin film was produced on the substrate by the method of 1.4; 80 nm source and drain electrodes were formed by vapor deposition in the major axis direction to manufacture a top-contact bottom-gate type OFET; and the field-effect mobility in the major axis direction was measured.

### 3.3 Evaluation of the mobility

When a positive or negative bias is applied on the gate electrode, the FET works in the depletion mode or the accumulation mode. The C8BTBT exhibited a property characteristic of a p-type organic semiconductor in which when the gate voltage (VG) is made negative, a current flows by positive hole injection. Respective mobilities of the C8BTBT oriented film and a C8BTBT spin coat film were calculated from the I_{DS}-V_{DS} property and I_{DS}-V_{G} property of the C8BTBT oriented film in the major axis direction, and the I_{DS}-V_{DS} property and I_{DS}-V_{G} property of the C8BTBT spin coat film. The calculation used the expression (1) usually used.
(Expression 1)
wherein µ: hole mobility [cm²/Vs], L: channel length, W: channel width, Cox: capacitance of SiO₂ (6.91×10⁻⁹ F/cm²), and Vt: threshold voltage.
Here, the channel length and the channel width of the oriented C8BTBT film were exactly estimated by microscopic observation. The mobility of the FET using the C8BTBT oriented film was 2.10 cm²/Vs; the threshold voltage thereof was -6.45 V; and the on/off ratio thereof was 4.05×10⁶.

### Comparative Example 1

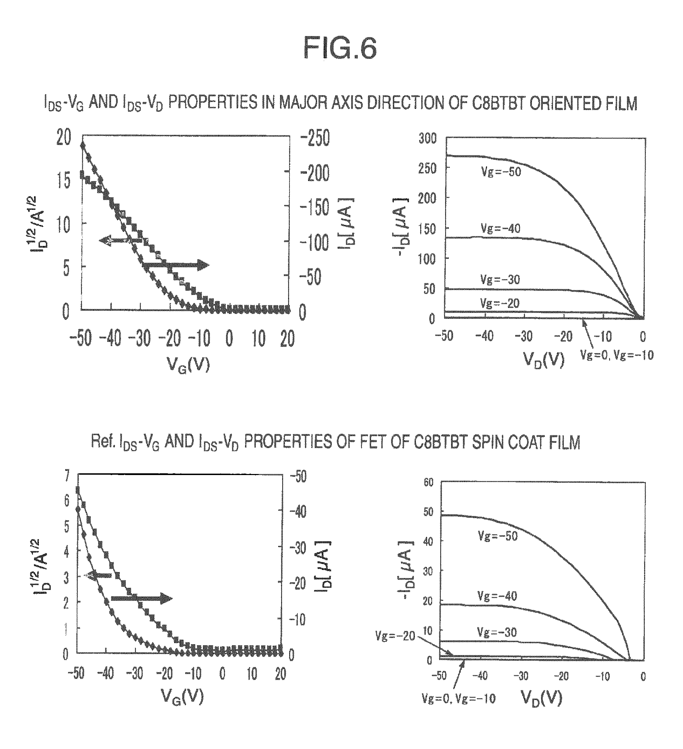

An organic thin film was fabricated by using the C8BTBT solution prepared in 1.4 of Example 1, and by a spin coat method (at 3,000 rpm for 60 sec, rotation coating) known as a usual coating method; and the mobility of the OFET was evaluated by the same means as in 3 of Example 1. The calculated hole mobility thereof was 2.21×10⁻² cm²/Vs; the threshold voltage thereof was -12.1 V; and the on/off ratio thereof was 5.09×10³. The mobility of the C8BTBT oriented film fabricated in Example 1 indicated an about 100 times higher value than that of the spin coat film (see Fig. 6).

### Example 2

### 4. Fabrication of a TIPS-pentacene (compound (10)) oriented film

A TIPS-pentacene toluene solution (0.5% by weight) was prepared by the same operation as in Example 1. A substrate (Si or glass) was subjected to ultrasonic cleaning with a detergent, an ion-exchange water and acetone each for 15 min. The 1.6 µm-epoxy mold having the periodical groove structure was put on the substrate in the air atmosphere, and heated at 80°C to 90°C for 2 min to thereby cause the mold and the substrate to closely adhere. The TIPS-pentacene solution was cast on the outside of the mold at room temperature; and the TIPS-pentacene solution was introduced in vacant spaces constituted of the substrate and the recesses by the capillary force. After the solvent completely evaporated (after 10 to 15 min), the mold was removed to thereby form a TIPS-pentacene oriented film.

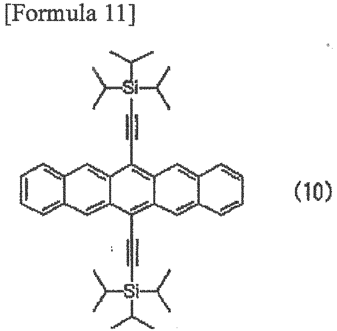

### 5. Evaluation of the structure of the TIPS-pentacene oriented film

### 5.1 Observation by AFM of the TIPS-pentacene oriented film

It was observed by cross-sectional profiling that the height of linear films was about 200 nm, which corresponded to a reduction of 20 nm from 220 nm being the height of the grooves of the mold; and this conceivably corresponded to the amount of the solvent having evaporated along with the solvent drying. The pitch width of the films was about 1.6 µm, and the width of the linear films was about 1 µm, which was coincident with the groove width of the mold.

### 5.2 The XRD result of the TIPS-pentacene oriented film

In the XRD pattern, peaks corresponding to spacings of 1.640 nm, 0.824 nm, 0.548 nm and 0.329 nm were recognized and assigned to (001), (002), (003) and (005) planes of the TIPS-pentacene crystal, respectively.

### 5.3 TEM observation of the TIPS-pentacene oriented film

The line shape of the TIPS-pentacene corresponding to the period of the mold was confirmed in the TEM image. The HRED image formed a net pattern with diffraction spots corresponding to spacings of 0.76 nm⁻¹ and 0.74 nm⁻¹, which was coincident with a diffraction image by c-axis projection (a of Fig. 5). Since the HRED was diffraction from a region of about 150 µm in diameter, the TIPS-pentacene forming lines crystallized like single crystals, and the b* axis oriented vertical to the groove direction of the mold. However, depending on places, twin crystals sharing the b* axis (vertical to the mold) were observed (b of Fig. 5).

From the above, it has been found that the method for producing an organic semiconductor thin film according to the present invention can form a single-domain single crystalline organic semiconductor thin film exhibiting high semiconductor properties in its channel without using any vacuum deposition method and any complicated fine control for crystal growth in fabrication of a semiconductor layer.

### Reference Signs List

Fig. 1 and Fig. 2
   1 SOURCE ELECTRODE
   2 SEMICONDUCTOR LAYER
   3 DRAIN ELECTRODE
   4 INSULATOR LAYER
   5 GATE ELECTRODE
   6 SUBSTRATE
   7 PROTECTION LAYER
Fig. 3
   1 MOLD
   2 SUBSTRATE
   3 ORGANIC SEMICONDUCTOR SOLUTION
   4 ORGANIC SEMICONDUCTOR THIN FILM

## Claims

1. A method for producing an organic semiconductor thin film, comprising disposing a mold having a recess on a substrate, and introducing an organic semiconductor solution into a gap formed by the recess and the substrate.

2. The method for producing an organic semiconductor thin film according to claim 1, wherein the introduction of the organic semiconductor solution is followed by removing the mold to form the organic semiconductor thin film.

3. The method for producing an organic semiconductor thin film according to claim 1 or 2, whether the introduction of the organic semiconductor solution into the mold is followed by evaporating a solvent thereof to form the organic semiconductor thin film.

4. The method for producing an organic semiconductor thin film according to any one of claims 1 to 3, wherein the introduction of the organic semiconductor solution is performed by a capillary force or a mechanical action.

5. The method for producing an organic semiconductor thin film according to any one of claims 1 to 4, wherein the introduction of the organic semiconductor solution and/or the separation of the mold is followed by carrying out a heat treatment to form the organic semiconductor thin film on the substrate.

6. The method for producing an organic semiconductor thin film according to claim 5, wherein the heat treatment is carried out at a temperature of 20°C or higher and 200°C or lower.

7. The method for producing an organic semiconductor thin film according to any one of claims 1 to 6, wherein the obtained organic semiconductor thin film is in a single domain crystal form.

8. The method for producing an organic semiconductor thin film according to any one of claims 1 to 7, wherein the mold is produced from a curable resin, a solvent, a polymerization initiator and a curing accelerator.

9. The method for producing an organic semiconductor thin film according to claim 8, wherein the curable resin comprises an epoxy resin.

10. The method for producing an organic semiconductor thin film according to any one of claims 1 to 9, wherein the organic semiconductor solution comprises a low-molecular organic semiconductor compound.

11. The method for producing an organic semiconductor thin film according to any one of claims 1 to 9, wherein the organic semiconductor solution comprises a high-molecular organic semiconductor compound.

12. The method for producing an organic semiconductor thin film according to any one of claims 1 to 9, wherein the organic semiconductor solution comprises a mixture of a low-molecular organic semiconductor compound and a high-molecular organic semiconductor compound.

13. The method for producing an organic semiconductor thin film according to claim 10 or 12, wherein the organic semiconductor solution comprises a compound represented by Formula (1): 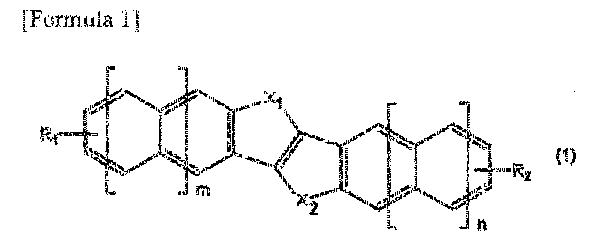 wherein X₁ and X₂ each independently represent a sulfur atom or a selenium atom; R₁ and R₂ each independently a hydrogen atom, an alkyl group, an aryl group, an alkoxyl group or an alkoxyalkyl group, and R₁ and R₂ may be identical or different; and m and n each independently represent 0 or 1.

14. The method for producing an organic semiconductor thin film according to claim 11, wherein the organic semiconductor solution further comprises a semiconductive or an insulative high-molecular compound.

15. An organic electronic device comprising an organic semiconductor thin film according to any one of claims 1 to 14.

16. An organic transistor comprising an organic semiconductor thin film according to any one of claims 1 to 14.
